Europäisches Patentamt

European Patent Office

Office européen des brevets

(11) Publication number: **0 089 836**
A2

# (12) EUROPEAN PATENT APPLICATION

(21) Application number: **83301539.9**

(22) Date of filing: **18.03.83**

(51) Int. Cl.³: **G 11 C 5/00**

(30) Priority: **19.03.82 JP 43977/82**

(43) Date of publication of application:
**28.09.83 Bulletin 83/39**

(84) Designated Contracting States:
**DE FR GB**

(71) Applicant: FUJITSU LIMITED
1015, Kamikodanaka Nakahara-ku
Kawasaki-shi Kanagawa 211(JP)

(72) Inventor: Aoyama, Keizo
11-28, Tsukimino 1-chome
Yamato-shi Kanagawa 242(JP)

(72) Inventor: Yamauchi, Takahiko
Iseya-so 2F No. 1 49 Kitaya-cho Nakaharu-ku
Kawasaki-shi Kanagawa 211(JP)

(72) Inventor: Seki, Teruo
Dai-2 Yayoi-so No. 5, 5-2 Shimoshinjo 3-chome
Nakahara-ku Kawasaki-shi Kanagawa 211(JP)

(74) Representative: Fane, Christopher Robin King et al,
HASELTINE LAKE & CO. Hazlitt House 28 Southampton
Buildings Chancery Lane
London, WC2A 1AT(GB)

(54) Static-type semiconductor memory device.

(57) A static-type semiconductor memory device includes peripheral circuits (20, 21), provided with at least a decoder, and memory cells (25). A high-voltage generating unit is provided in the chip so that a first power-source voltage ($V_{cc}$) supplied from an external unit is boosted to a second power source voltage level ($V_{cc}^*$) higher than said first power source voltage level. The first power-source voltage is supplied to the peripheral circuits and the second power-source voltage is supplied to the memory cells, thereby improving their stability in the presence of disturbances such as α-rays.

Fig. 6

EP 0 089 836 A2

Croydon Printing Company Ltd.

STATIC-TYPE SEMICONDUCTOR MEMORY DEVICE

The present invention relates to a static-type semiconductor memory device, and more particularly to such a device having peripheral circuits, including at least a decoder, in addition to memory cells.

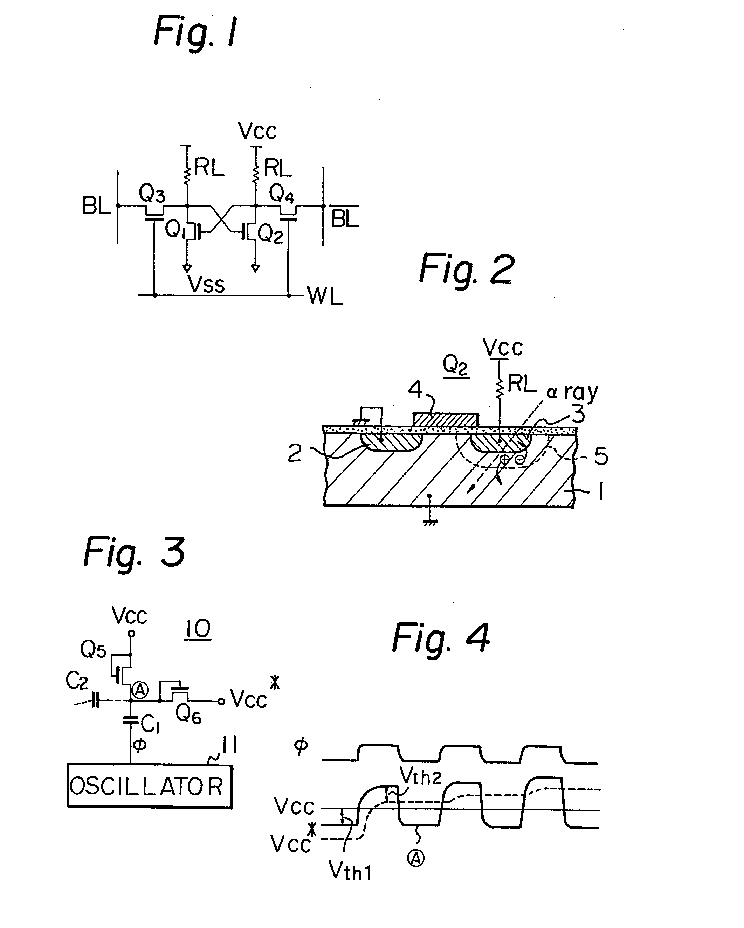

In a static random access memory (RAM) chip of the type shown in Fig. 1 of the accompanying drawings, using metaloxide semiconductor (MOS) transistors, if alpha rays enter into the chip from the exterior, ionization can take place in the depletion layer of a transistor in the vicinity of the source or drain, as shown in Fig. 2, thereby giving rise to the generation of pairs of electrons and positive holes. The positive holes are absorbed by the grounded substrate and the electrons are absorbed by the drain. The potential changes little in the substrate but drops temporarily in the drain since the drain is connected to a load resistor RL, which has a high resistance (on the order of several gigohms), and a given period of time is required to supply an electric charge (positive holes) to neutralize the absorbed electrons. At the same time, even if alpha rays enter the source, the potential does not drop since the source is directly grounded. When a memory cell is irradiated with alpha rays, the high potential side approaches the potential of the low potential side since the output level of the low potential side of the cell remains constant whereas the output level of the high potential side of the cell drops. Consequently, the data in the cell may be inverted during a reading operation or, in the worst case, the data in the cell may be inverted even when it is being stored. When alpha rays fall on the substrate perpendicularly, they traverse the depletion layer for a short distance, and a small number of electron-hole pairs are generated so that the drain potential drops little; but when they fall on the substrate at a small angle nearly parallel with the surface of the substrate, they traverse the depletion layer for a greater distance, and an increased number of electron-hole pairs are generated, with the result that the drain potential markedly decreases. Accordingly, the high potential level and low potential level produced by the cell may become inverted.

The above-mentioned problems can be avoided if the high potential level of the drain is quickly restored when the drain is irradiated with alpha rays. To restore the high potential level of the drain, the resistance of the load may be reduced. This, however, can cause difficulties in achieving a high degree of integration and results in an increase in electric power consumption when the data is being stored.

It is desirable to provide a static-type semiconductor memory device which more stably holds data, irrespective of disturbances such as alpha radiation, without electric power consumption being increased unacceptably.

It is also desirable to provide a static-type semiconductor memory device which is less affected by disturbances than are conventional static-type semiconductor memory devices.

According to one aspect of the present invention, there is provided a static-type semiconductor memory device, comprising memory cells and peripheral circuitry including a decoder, characterized by means for supplying power to the said memory cells at a higher voltage than that at which power is supplied to the peripheral circuitry when the device is in use.

Reference will now be made, by way of example, to the accompanying drawings, in which:-

Fig. 1 is a circuit diagram of a conventional static memory cell;

Fig. 2 is a diagram illustrating the effect of alpha rays on the conventional static memory cell of Fig. 1;

Fig. 3 is a diagram showing the construction of a high-voltage generating unit for use in an embodiment of the present invention;

Fig. 4 is a time chart showing voltage wave forms in each portion of the high-voltage generating unit shown in Fig. 3;

Fig. 5 is a diagram schematically illustrating part of a static RAM embodying the present invention;

Fig. 6 is a schematic circuit diagram of an embodiment of the present invention; and

Fig. 7 is an embodiment of the ring oscillator shown in Fig. 3.

Figure 1 is a diagram of an equivalent circuit of a conventional static memory cell in a general MOS static-type RAM in which RL denotes a load resistor, $Q_1$ and $Q_2$ denote transistors used as drivers, $Q_3$ and $Q_4$ denote transfer gates, BL and $\overline{BL}$ denote a pair of bit lines, and WL denotes a word line. A static memory device fundamentally uses flip-flop circuits. Therefore, either one of the transistors $Q_1$ and $Q_2$ is rendered conductive to hold data. For instance, if the transistor $Q_1$ is rendered conductive and the transistor $Q_2$ is rendered nonconductive, the bit line BL assumes a low-level L memory state and the bit line $\overline{BL}$ assumes a high-level H memory state. The level L is grounded ($V_{SS}$) via the transistor $Q_1$. The level H, on the other hand, is connected to the power source $V_{CC}$ via the load resistor RL.

In Fig. 2, the construction of the transistor $Q_2$ , which is an N-channel transistor, is shown. The substrate 1 is a P-type substrate, and the drain 2 and source 3 are an $N^+$-type drain region and source region. Due to the wiring of Fig. 1, the source 2 is grounded and the drain 3 is connected to the power source $V_{CC}$ via the load resistor RL. The gate electrode 4 is connected to the drain of the transistor $Q_1$ , as is shown in Fig. 1, and the substrate 1 is usually grounded. Under the conditions given in Fig. 1, the gate electrode 4 has a low potential, and a channel inversion layer is not formed on the surface of the substrate 1. Therefore, the potential of the drain 3 is maintained at a high level due to the power source $V_{CC}$, and a depletion layer 5 surrounds the drain 3 in the substrate 1. Under these conditions, if alpha rays from an external source traverse the depletion layer 5, ionization takes place therein, giving rise to the generation of pairs of electrons ⊖ and positive holes ⊕. The positive holes ⊕ are absorbed by the grounded substrate 1, and the electrons ⊖ are absorbed by the drain 3. The potential changes little in the substrate 1. The potential, however, drops temporarily in the drain 3 since the drain is connected to the load resistor RL, which has a high resistance (on the order of several gigohms), and a given period of time is required to supply an electric charge (positive holes) to neutralize the absorbed electrons ⊖. At the same time, even if alpha rays enter the source 2, the potential of the source does not drop since the source is directly grounded. When the cell is irradiated with alpha rays, the high potential approaches the low potential since the output level of the low potential side of the cell remains constant whereas the output level of the high potential side of the cell drops. Consequently, the data stored in the cell may be inverted during the reading operation or, in the worst case, the data may be inverted even when it is being stored. That is, when the alpha rays fall on the substrate perpendicularly, they traverse the depletion layer for a short distance, and a small number of electron-hole pairs are generated so that the drain potential drops little; but when they fall on the substrate at a small angle nearly in parallel with the surface of the substrate, they traverse the depletion layer for a greater distance, and an increased number of electron-hole pairs are generated, with the result that the drain potential markedly decreases. Accordingly, the high potential level and low potential level produced by the cell are often inverted.

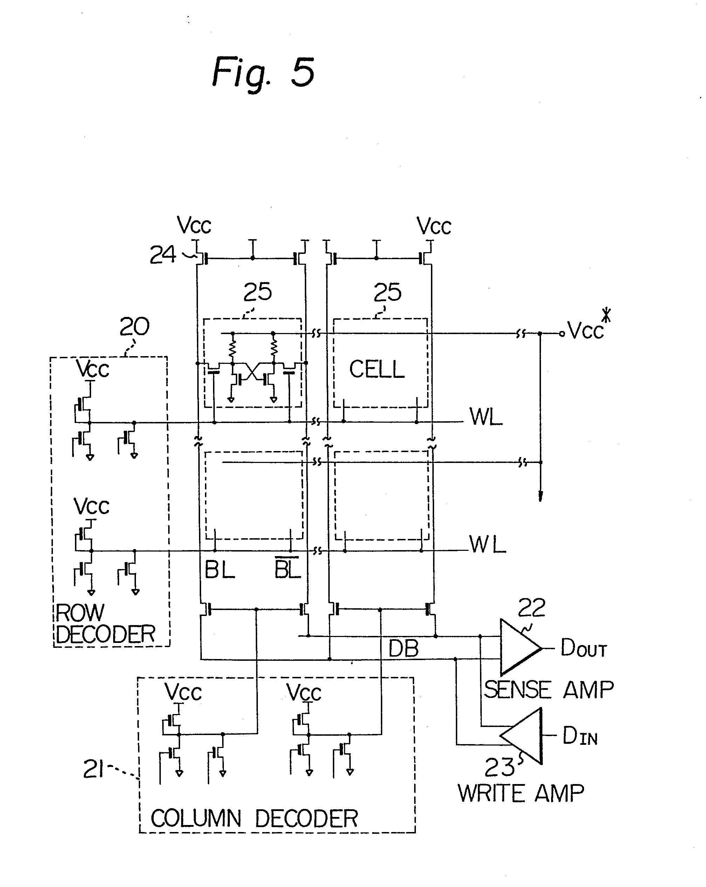

Figures 3 to 5 illustrate an embodiment of the present invention, Fig. 3 being a diagram of a high-voltage generating unit provided in a chip, Fig. 4 being a time chart showing voltage wave forms, and Fig. 5 being a diagram illustrating part   of a static RAM embodying   the present invention.  Referring to Fig. 3, in the high-voltage generating unit 10, the potential at one terminal of the capacitor $C_1$ is pushed up periodically by the output $\emptyset$ of the ring oscillator 11, with the result that the potential at the other terminal Ⓐ of the capacitor $C_1$ assumes a second power-source voltage which is higher than the voltage of the first power source $V_{CC}$ supplied from an external unit.  When the clock signal $\emptyset$ assumes a low potential (ground) level, the potential at point Ⓐ is equal to a value $(V_{CC} - Vth_1)$ obtained by subtracting the threshold voltage $Vth_1$ of the diode-connected transistor $Q_5$ from the power-source voltage $V_{CC}$.  When the clock signal $\emptyset$ assumes a high potential level $(V_{CC})$, on the other hand, the potential at one terminal of the capacitor $C_1$ is pushed up, and the potential at point Ⓐ increases from the initial level of $(V_{CC} - Vth_1)$ to

$$(V_{CC} - Vth_1 + \frac{C_1}{C_1 + C_2} V_{CC}),$$

where $C_2$ denotes the stray capacity at point Ⓐ.  When the potential at point Ⓐ becomes higher than the level of the output $V_{CC}^*$ of the booster circuit by more than the threshold level $Vth_2$ of the diode-connected transistor $Q_6$ , the diode--connected transistor $Q_6$ is rendered conductive, and the boosted level at point Ⓐ is absorbed by the output $V_{CC}^*$.  Next, even when the clock signal $\emptyset$ assumes a low potential level again and the level at point Ⓐ decreases to $(V_{CC} - Vth_1)$ accordingly, the level of the output $V_{CC}^*$ does not decrease since the diode-connected transistor $Q_6$ works as a diode in a reverse direction.  The clock signal $\emptyset$ then assumes a high potential level again, i.e., the potential level becomes high at point $\textcircled{A}$, and a pumping action is performed repetitively so that the output $V_{CC}^{*}$ is boosted and gradually approaches

$$(V_{CC} - Vth_1 + \frac{C_1}{C_1 + C_2} V_{CC} - Vth_2).$$

In an MOS integrated circuit, the capacitor $C_1$ is suitably made up of an MOS capacitor in which the gate electrode (point $\textcircled{A}$) of an MOS transistor assumes a negative polarity, and another electrode is made up of a source and a drain that are short-circuited. The capacitor $C_1$ may, of course, be an ordinarily employed one.

In the static RAM shown in Fig. 5, the wiring of the power-source system can be classified into two systems. One system is connected to the external power source $V_{CC}$ and includes peripheral circuits such as the row decoder 20, which has a NOR-gate construction, the column decoder 21, which is constructed in the same manner as the row decoder, the sense amplifier 22, the write amplifier 23, the bit-line load 24, and the like. The other system is connected to the above-mentioned high-voltage power source $V_{CC}^{*}$ generated in the chip. A high voltage, however, is applied to the memory cells 25 only, in order to reduce the consumption of electric power. Thus, when the power-source voltage $V_{CC}^{*}$ for the memory cells 25 is higher than the power-source voltage $V_{CC}$, more electric charges are stored in the drain 3 than when the power-source voltage $V_{CC}$ is used. Therefore, even when the electrons $\ominus$ are injected due to alpha radiation, the high potential level of the drain 3 is not decreased much. Accordingly, erroneous operation stemming from the inversion of the cell data can be prevented. Further, despite the high power-source voltage $V_{CC}^{*}$, the consumption of electric power increases very little, this being due to the high resistance of the load resistor RL. In terms of electric current, a current on the order of several microamperes flows into the cells, and a current on the order of 10 to 100 milliamperes flows into the peripheral circuits.

However, since the peripheral circuits, which consume a large amount of electric power, are operated by an ordinary power source $V_{CC}$ , the consumption of electric power as a whole increases by a negligibly small amount.

The input data $D_{IN}$ is written into the memory by the write amplifier 23 and the data bus DB system by setting the bit lines BL, $\overline{BL}$ of the data bus DB system to a high potential level or a low potential level. The power source $V_{CC}$ is used for this purpose. Therefore, the high potential level of the cells 25 is electrically charged by the power source $V_{CC}^{*}$ via a high resistance after the data has been written, and the potential rises gradually. If alpha rays are irradiated during this period, the period during which the potential gradually rises, however, is very short compared with the period during which the memory is operated and can be regarded as being negligibly short. If it is desired to eliminate even such a short period of time, however, the data may also be written by the power-source voltage $V_{CC}^{*}$. To read the data, the transfer gate is opened to transmit the cell potential to the bit lines BL, $\overline{BL}$, and the data is read by the sense amplifier 22 via the data bus DB to produce an output $D_{OUT}$ in a customary manner. However, since the gate voltage of the transfer gate is $V_{CC}$ , the cell potential of the high potential level transmitted to the bit lines is limited to $V_{CC}$ - Vth in a manner the same as that of the conventional devices. On the low potential side, the bit-line potential is dropped to the low potential level (ground level) via the transfer gate in the conventional manner. That is, the data is read in a customary manner even when the memory cells are driven by the power-source voltage $V_{CC}^{*}$ , which is higher than the power-source voltage $V_{CC}$ , with no difficulties resulting.

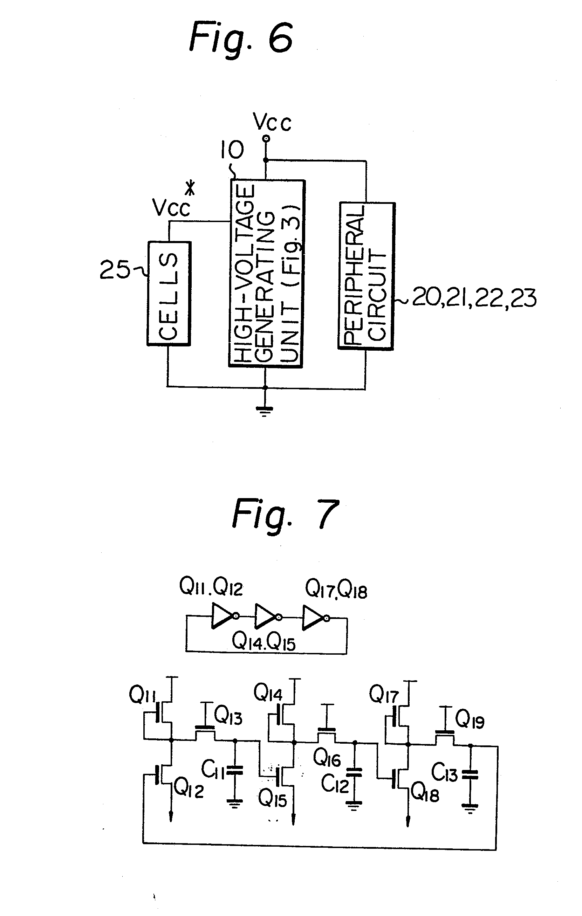

Figure 6 shows the relationship between the source voltage $V_{CC}$ , the boosted source voltage $V_{CC}^{*}$ , the high-voltage generating unit 10, the cells 25, and the peripheral circuits 20, 21, 22, and 23.

Figure 7 shows an embodiment of the ring oscillator 11 shown in Fig. 3. The ring oscillator in Fig. 7 is formed as a well-known ring oscillator having a three-stage negative inverter. That is, three pairs of transistors $Q_{11}$ , $Q_{12}$ , $Q_{14}$ , $Q_{15}$ , and $Q_{17}$ , $Q_{18}$ form the negative inverter circuits. The transistors $Q_{11}$ , $Q_{14}$ , and $Q_{17}$ may be formed as depletion transistors, and the transistors $Q_{12}$ , $Q_{15}$ , and $Q_{18}$ may be formed as enhancement transistors. The transistors $Q_{13}$ , $Q_{16}$ , and $Q_{19}$ may be formed as depletion-type transistors or as enhancement-type transistors so as to form a resistor between the inverter stages. However, the resistor is not always necessarily. Capacitors $C_{11}$ , $C_{12}$ , and $C_{13}$ are used for delaying signal wave forms so that the output of the transistor $Q_{19}$ is fed back to the gate of the transistor $Q_{12}$. These capacitors may be formed in the same manner as the capacitor $C_1$ shown in Fig. 3.

## CLAIMS

1. A static-type semiconductor memory device comprising peripheral circuits, provided with at least a decoder, memory cells, a first power-source voltage supplied from an external unit, and a high-voltage generating unit provided in the chip to boost said first power-source voltage to a second power-source voltage level higher than said first power-source voltage level, wherein the power source for the peripheral circuits utilizes said first power-source voltage, and the power source for the memory cells utilizes said second power-source voltage.

2. A static-type semiconductor memory device according to claim 1, wherein said high-voltage generating unit comprises an input terminal connected to said first power-source voltage, a first transistor in which the drain and the gate thereof are connected to each other and to said input terminal, a capacitor having one terminal connected to the source of said first transistor, an oscillator having an output connected to the other terminal of said capacitor, a second transistor in which the drain and the gate thereof are connected and in which the drain is connected to the junction point of said first transistor and said capacitor and the source is connected to the output of said high--voltage generating unit.

3. A static-type semiconductor memory device according to claim 2, wherein said capacitor is formed as an MOS capacitor in which the gate of the MOS transistor is used as one terminal and another terminal is formed by connecting the source and the drain of said MOS transistor.

4. A static-type semiconductor memory device according to claim 2, wherein said capacitor is formed as a conventional condenser.

5. A static-type semiconductor memory device according to claim 2, wherein said oscillator is formed as a ring oscillator.

6. A static-type semiconductor memory device, comprising memory cells and peripheral circuitry including a decoder, characterized by means for supplying power to the said memory cells at a higher voltage than that at which power is supplied to the peripheral circuitry when the device is in use.

7. A static-type semiconductor memory device, comprising memory cells and peripheral circuitry which includes a decoder and is powered from an external supply when the device is in use, characterized by voltage-boosting means incorporated in the device so as to supply power, derived from said external supply, to the said memory cells at a voltage higher than that at which power is supplied to the peripheral circuitry when the device is in use.

# Fig. 1

# Fig. 2

# Fig. 3

# Fig. 4

# Fig. 5

## Fig. 6

## Fig. 7